# EUROPÄISCHE PATENTSCHRIFT

(11) **EP 0 292 804 B1**
(45) Veröffentlichungstag und Bekanntmachung des Hinweises auf die Patenterteilung: **26.01.1994**
(21) Anmeldenummer: 88107671.5
(22) Anmeldetag: 13.05.1988
(51) Int. Cl.: H03K 17/78

(54) **Schaltungsanordnung zur potentialfreien Erfassung von binären Signalen**
Circuit arrangement for the electrically isolated acquisition of binary signals
Montage pour la saisie sans potentiel fixe de signaux binaires

(30) Priorität: 25.05.1987 DE 3717591
(43) Veröffentlichungstag der Anmeldung: 30.11.1988
(73) Patentinhaber: Hartmann & Braun Aktiengesellschaft, 60484 Frankfurt am Main (DE)
(72) Erfinder: Ferling, Klaus, D-5628 Heiligenhaus (DE); Ermert, Uwe, D-4030 Ratingen 8 (DE); Theis, Karl S., D-5628 Heiligenhaus (DE)
(74) Vertreter: Meissner, Peter E., Dipl.-Ing.

(56) Entgegenhaltungen:
- DE-A- 2 236 425
- DE-A- 3 107 742
- DE-A- 3 322 896
- GB-A- 2 067 866
- IBM TECHNICAL DISCLOSURE BULLETIN, Band 18, Nr. 11, April 1976, New York, US D.G.BINGHAM et al. "Current sensor" Seite 3545
- U Tietze, Ch Schenk, "Halbleiter-Schaltungstechnik", 2te Auflage, 1971, Seiten 292-295, 334-339, 380-383

## Beschreibung

Die Erfindung betrifft eine Schaltungsanordnung zur potentialfreien Erfassung von binären elektrischen Signalen nach dem Oberbegriff des Anspruches 1.

Aus der DE-OS 33 22 896 sind derartige Schaltungsanordnungen bekannt. Mit ihrer Hilfe werden binäre Steuersignale unterschiedlicher Impulshöhe von einer Schaltanlage durch einen Optokoppler entkoppelt und einer weiteren elektronischen Verarbeitung zugeführt. In den bekannten Schaltungen werden die Signale entweder über umschaltbare Vorwiderstände in den Optokoppler eingespeist oder es wird mit einem konstanten Strom gearbeitet, den die Schaltungsanordnung aus den binären Signalen gewinnt.

Die Lösung mit einer Anpassung über Vorwiderstände hat den Nachteil der großen Varianz bei unterschiedlichen Steuersignalen. Die Lösung mit konstantem Strom hat den Nachteil, daß bei Steuersignalen mit kleiner Impulshöhe die Leistungsaufnahme der Schaltung sehr gering ist und damit schon geringe überlagerte Störenergien zu Übertragungsfehlern führen können.

Ausgehend von einer Schaltungsanordnung der eingangs genannten Art besteht die Aufgabe der Erfindung darin, diese Schaltung so zu verbessern, daß die Eingangsverlustleistung für den gesamten Steuerspannungsbereich der Eingangssignale im wesentlichen konstant ist, um den Störabstand der Schaltung zu erhöhen.

Die Aufgabe ist mit den im Kennzeichen des Anspruches 1 angegebenen Merkmalen gelöst.

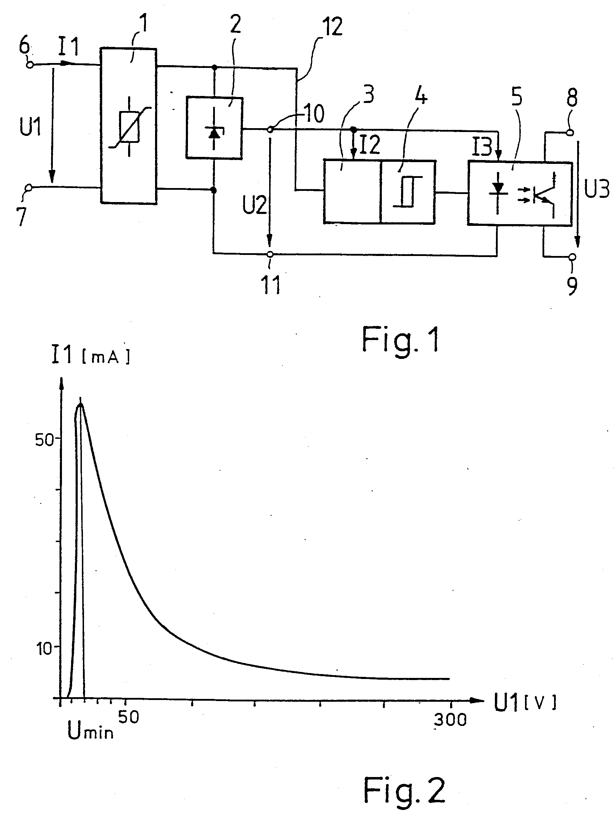

Ein vorteilhaftes Ausführungsbeispiel der Erfindung wird anhand der Figuren 1 und 2 näher erläutert.

Es zeigen
- Figur 1: das Blockschaltbild einer Schaltungsanordnung zur potentialfreien Erfassung von elektrischen Binärsignalen und
- Figur 2: die Eingangskennlinie der Schaltungsanordnung nach Figur 1.

Das Blockschaltbild der Schaltungsanordnung nach Figur 1 enthält eine Schutzschaltung 1, eine Spannungsregelschaltung 2, eine Steuerschaltung 3 mit einer Schaltstufe 4 und einen Optokoppler 5.

Die in die Eingangsklemmen 6 und 7 eingespeisten elektrischen Binärsignale erzeugen an diesen Klemmen eine Eingangsspannung U1 und rufen einen Eingangsstrom I1 hervor. Die Eingangsspannung U1 passiert die Schutzschaltung 1, die den Binärsignalen überlagerte höherfrequente Störspannungen herausfiltert, und speist eine Spannungsregelschaltung 2, die eine Ausgangsspannung U2 konstanter Amplitude zwischen den Klemmen 10 und 11 erzeugt. Diese Ausgangsspannung U2 versorgt die Steuerschaltung 3 und die Schaltstufe 4 mit dem Laststrom I2 und speist eine Sendediode im Optokoppler 5 mit einem Sendestrom I3. Entsprechend diesem Sendestrom I3 in dem Eingang des Optokopplers 5 ändert dessen Fototransistor den Widerstand seiner Kollektor-Emitter-Strecke, so daß an den Ausgangsklemmen 8 und 9 eine der Eingangsspannung U1 entsprechende, potentialmäßig getrennte binäre Ausgangsspannung U3 zur Verfügung steht.

Die Steuerschaltung 3 besitzt eine nichtlineare Strom-Spannungs-Kennlinie und erzwingt demzufolge einen Laststrom I2 für die Spannungsregelschaltung 2, der umgekehrt proportional zur Eingangsspannung U1 ist. In den Optokoppler 5 fließt dagegen ein konstanter Sendestrom I3, dessen Stärke von der Ausgangsspannung U2 und dem ohmschen Vorwiderstand der Sendediode abhängt.

Die Aufgabe der Schaltstufe 4, die mit einer Schalthysterese versehen ist, besteht darin, den Optokoppler 5 erst ab einer definierten Mindesamplitude der Eingangsspannung U1 für eine Übertragung freizuschalten. Die Schaltstufe 4 und die Steuerschaltung 3 werten die Amplitude der Eingangsspannung U1 aus; sie werden daher über eine Leitung 12 mit dem für ihre Funktion notwendigen Steuerstrom versorgt. Dieser Steuerstrom ist gegenüber dem Eingangsstrom I1 vernachlässigbar, so daß die Summe aus dem Laststrom I2 und dem Sendestrom I3 dem Eingangsstrom I1 entspricht.

Der Vorteil dieser Schaltung besteht darin, daß keine Anpassung an die Höhe der Eingangsspannung U1 erforderlich ist. Für den praktischen Anwendungsfall heißt das, daß binäre Eingangssignale von beispielsweise 24 Volt bis 250 Volt Amplitude verarbeitet und übertragen werden können. Die Eingangsverlustleistung der Schaltungsanordnung bleibt im gesamten Amplituden-Bereich im wesentlichen konstant, wobei die Sendediode des Optokopplers 5 mit konstantem Sendestrom I3 betrieben wird. Aufgrund der gewählten Spannungs-Strom-Charakteristik wird eine hohe Unempfindlichkeit der Schaltungsanordnung gegen dynamische und statische (Isolationsverluste) Störsignale erreicht.

Figur 2 zeigt den nichtlinearen Verlauf der Strom-/Spannungs-Kennlinie der Schaltungsanordnung nach Figur 1, gemessen an den Eingangsklemmen 6 und 7. Bei kleinen Eingangsspannungen U1 ≧ 20 Volt fließt ein hoher Strom von ca. 60 mA. Mit steigender Eingangsspannung bis 300 Volt fällt der Strom nichtlinear auf ca. 4 mA ab. Die Eingangsverlustleistung beträgt hierbei gleichbleibend ca. 1,2 VA. Sinkt die Eingangsspannung U1 unter den Minimalwert Uₘᵢₙ ab, unterbricht die Schaltstufe 4 die optische Übertragung durch den Optokoppler 5.

## Patentansprüche

1. Schaltungsanordnung zur potentialfreien Erfassung von binären elektrischen Signalen (U1) unterschiedlicher Amplitude mit einem Optokoppler (5) als Element zur Potentialtrennung, dessen einer Eingang an einen der Eingangsanschlüsse (6, 7) angeschlossen ist, und mit einer Spannungsregelschaltung (2) zwischen den Eingangsanschlüssen (6, 7), die an ihrem Ausgang aus den binären Signalen abgeleitete Signale (U2) konstanter Amplitude abgibt, gekennzeichnet dadurch, daß die Signale (U2) konstanter Amplitude dem anderen Eingang des Optokopplers (5) zugeführt sind und gleichzeitig in eine Steuerschaltung (3) eingespeist werden, die einen Laststrom (I2) für die Spannungsregelschaltung (2) derart erzeugt, daß die von der Schaltungsanordnung aufpenommene Leistung im wesentlichen Konstant ist.

2. Schaltungsanordnung nach Anspruch 1, dadurch gekennzeichnet, daß eine Schaltstufe (4) vorgesehen ist, die den Optokoppler (5) ab einer definierten Mindest-Amplitude der binären Signale (S1) an den Eingangsanschlüssen (6, 7) freigibt.

3. Schaltungsanordnung nach Anspruch 1, dadurch gekennzeichnet, daß zwischen den Eingangsanschlüssen (6, 7) und der Spannungsregelschaltung (2) eine Schutzschaltung (1) angeordnet ist, die die Schaltungsanardnung vor über die Eingangsanschlüsse eingekoppelte Störspannungen schützt.

## Claims

1. A circuit arrangement for the potential-free detection of binary electrical signals (U1) of different amplitudes with an optical coupler (5) as an element for potential separation, one input of which is connected to one of the input terminals (6, 7), and with a voltage regulation circuit (2) between the input terminals (6, 7), which emits at its output signals (U2) of constant amplitude derived from the binary signals, characterised in that the signals (U2) of constant amplitude are fed to the other input or the optical coupler (5) and are simultaneously fed into a control circuit (3) which generates a load current (I2) for the voltage regulation circuit (2) such that the power consumed by the circuit arrangement is essentially constant.

2. A circuit arrangement according to Claim 1, characterised in that a switching step (4) is provided which releases the optical coupler (5) as from a defined minimum amplitude of the binary signals (S1) at the input terminals (6, 7).

3. A circuit arrangement according to Claim 1, characterised in that a protective circuit (1) is located between the input terminals (6, 7) and the voltage control circuit (2), which protective circuit protects the circuit arrangement against interference voltages coupled in via the input terminals.

## Revendications

1. Circuit pour détecter indépendamment du potentiel des signaux électriques binaires (U1) de différentes amplitudes, comportant un coupleur opto-électronique (5) en tant qu'élément pour isoler le potentiel, dont une entrée est raccordée à un des raccords d'entrée (6,7), et un circuit de réglage de tension (2) entre les raccords d'entrée (6,7), qui, à sa sortie, délivre des signaux (U2), dérivés des signaux binaires, d'amplitude constante, caractérisé en ce que les signaux (U2) d'amplitude constante sont amenés à l'autre entrée du coupleur opto-électronique (5) et, simultanément, alimentent un circuit de commande (3) qui crée un courant de charge (I2) pour le circuit de réglage de tension (2) de sorte que la puissance reçue par le circuit est essentiellement constante.

2. Circuit selon la revendication 1,
caractérisé en ce qu'un étage de commutation (4) est prévu, qui libère le coupleur opto-électronique (5) à partir d'une amplitude minimale définie des signaux binaires (U1) aux raccords d'entrée (6,7).

3. Circuit selon la revendication 1,
caractérisé en ce que, entre les raccords d'entrée (6,7) et le circuit de réglage de tension (2), est agencé un circuit de protection (1) qui protège le circuit de tensions parasites introduites par l'intermédiaire des raccords d'entrée.
